# EUROPEAN PATENT SPECIFICATION

(11) **EP 1 715 528 B1**
(45) Date of publication and mention of the grant of the patent: **28.07.2010**
(21) Application number: 05447082.8
(22) Date of filing: 18.04.2005
(51) Int. Cl.: H01L 27/146

(54) **Photodiode array image sensor**
Bildsensorphotodiodenanordnung
Réseau de photodiodes capteurs d'image

(43) Date of publication of application: 25.10.2006
(73) Proprietor: Xenics N.V., 3001 Leuven (BE)
(72) Inventor: Bentell, Jonas, 3000 Leuven (BE)
(74) Representative: Van Malderen, Joëlle

(56) References cited:
- EP-A- 1 195 816
- US-A- 4 638 345
- US-A- 6 037 609
- US-B1- 6 690 074
- JI SOO LEE ET AL: "Analysis of CMOS Photodiodes. II. Lateral photoresponse" IEEE TRANSACTIONS ON ELECTRON DEVICES IEEE USA, vol. 50, no. 5, May 2003 (2003-05), pages 1239-1245, XP002345753 ISSN: 0018-9383
- HEHEMANN I ET AL: "A CMOS photodiode array with linearized spectral response and spatially distributed light intensity detection for the use in optical storage systems" ESSDERC 2002. PROCEEDINGS OF THE 32ND EUROPEAN SOLID-STATE DEVICE RESEARCH CONFERENCE UNIV. BOLOGNA BOLOGNA, ITALY, 2002, pages 431-434, XP002345754 ISBN: 88-900847-8-2

## Description

### Field of the invention

The present invention relates to arrays of photodiodes that are commonly used as image sensors in cameras or spectrometers. In particular, it relates to arrays of infrared diodes interconnected to imaging electronics fabricated on a chip separate from that containing the photodiodes.

### State of the art

A photodiode array is a surface divided into discrete areas, whereby each area contains one diode. The purpose of the photodiode array in imaging applications is the generation of currents proportional to the light incident on each diode on the surface, thus generating a map of incident light power. The currents from each diode are fed into electronic circuitry, that generates digital or analogue information about the temporal and spatial properties of the incident light field by mapping the current of each diode to its position in the light field at a given time. Each diode in the array is generally called a pixel, as the information from that pixel generally corresponds to a picture element, also called pixel, in the generated image information. For the information generation process to be spatially accurate, it is of importance that each light collecting area is clearly defined. A general overview of linear image sensing can be found in EP-B-0520516.

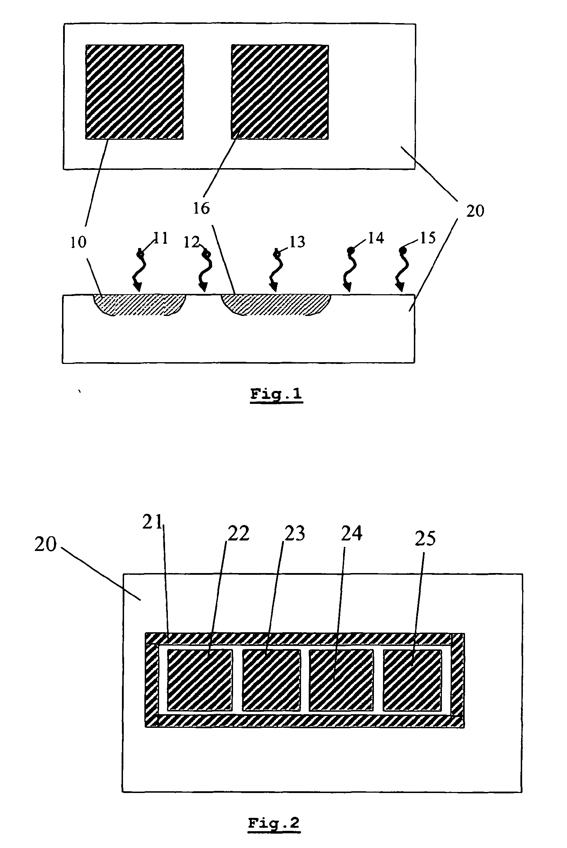

In some diode materials of high quality, the photocurrent of a diode is also dependent on diffusion currents. In such high quality materials, long diffusion lengths can make the light-collecting area less defined. Fig.1 (top view + side view) illustrates the effect of incident photons with long diffusion lengths. Two diodes (10 and 16) are manufactured on a common wafer chip (20). Photons incident on the chip (11, 12, 13, 14, 15) penetrate the chip material and generate charge carriers inside the material close to their points of incidence. The thus generated charge carriers generate a photocurrent in the diodes if they reach the PN-junction of a diode before recombining. In the case that the charge is generated in material far from the depletion region, such as it would be the case for photon (15), the charge may reach the PN-junction by diffusion from points far away from the diode. Since the purpose of an imaging array is to provide high spatial resolution, charge from areas far from the pixels is an unwanted contribution to the photocurrent. The smaller the pixels, the larger this problem becomes, since the proportional share of light collecting areas that surround the pixel areas becomes larger.

Three solutions to preventing charge collection from surrounding areas are:
● Reflecting or absorbing the incident light with metallisation on top of the device. The reflected light then is scattered and may return to the array, disturbing the image.
● Providing an implantation to enhance recombination. This is a difficult procedure to perform in small-pixel arrays and requires extra processing.
● Guard diode placement around the diode array. This is the best solution, since it can be done with high accuracy with no additional processing steps and does not reflect any light.

The guard solution to this problem involves the introduction of one or more extra diodes along the perimeter of the photodiode array. Such extra diodes are generally called guard diodes, guard rings or guards. Fig.2 depicts an array of four photodiodes (22, 23, 24, 25) fabricated on a common chip (20) surrounded by a guard (21). Charge carriers generated outside the area of the pixel array that could diffuse into the pixel array are collected by the PN-junction of the guard diode.

To prevent the guard from becoming saturated with charge, it has to be electrically connected in order to drain out the collected charge carriers, and charge has to be conducted along the guard from the point of charge collection to the electrical connection. As the diode material has a large, finite resistivity and as the guard must have an elongated shape to protect the full extension of an array, the electrical potential of the guard material will not be constant along the path of charge conduction.

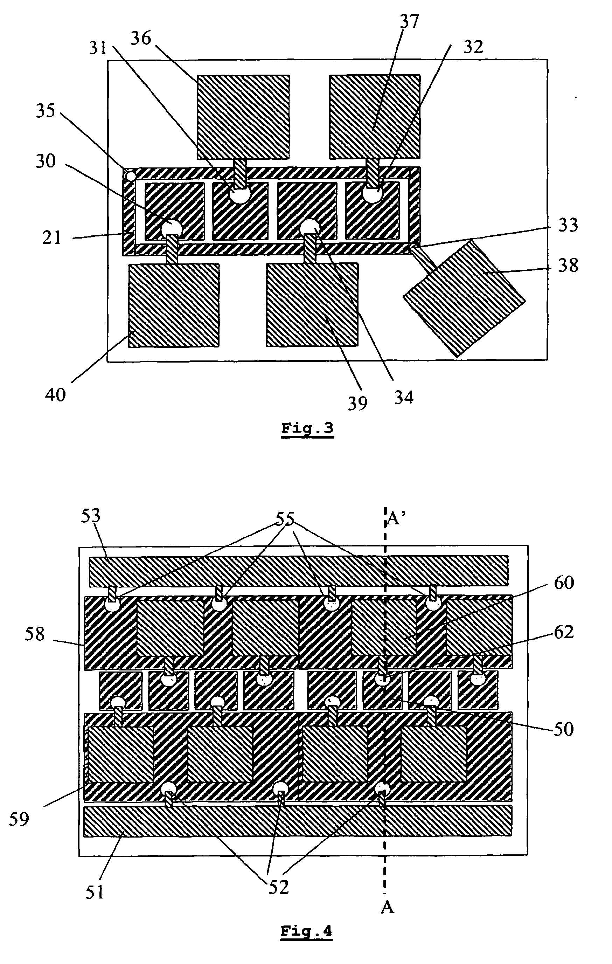

Fig.3 illustrates the drawback of connecting a surrounding guard diode electrically. The same pixel array as in Fig.2 is shown in Fig.3 with electrical connections to each pixel, called pixel contacts (30, 31, 32, 34). These electrical connections are in turn connected to bond pads (36, 37, 39, 40). The bond pads are typically residing on a dielectric that provides electrical isolation from the underlying semiconductor material. The guard is similarly connected though a dedicated guard contact (33) to a bond pad (38), which can be connected to a bias. The bias provides a function for draining the guard of collected charge. The drawback of this way of connecting the guard is that charge collected at a point far from the guard contact (33) (like e.g. point (35)) has a long conduction path to guard contact (33). This will cause a large difference in electrical potential along the length of the guard between point (35) and guard contact (33).

In patent application EP-999596-A2 a device is disclosed that enhances the response uniformity in a photodiode array, where the photocurrents are dependent on the electrical field strength inside the diodes. In that invention a guard diode is used to enable a uniform field in the imaging diodes. More specifically, it relates to diodes where the current is dependent on the field inside the diodes. It also presents a method for making it uniform over all pixels.

Lee et al shows, in IEEE transactions on electron devices vol. 50 no. 5 May 2003, another type of guard diode structures arranged to drain unwanted charge.

### Aims of the invention

The present invention aims to provide an image sensing device that overcomes the drawbacks of the prior art solutions.

### Summary of the invention

The present invention relates to an image sensing device comprising an array of photodiodes formed on a substrate provided with a semiconductor layer, wherein each photodiode is connected with a pixel contact to a bond pad, whereby said bond pad is electrically isolated from said semiconductor layer. The image sensing device further comprises at least one guard diode. This guard diode extends at least partially under and/or between the bond pads. Each of the at least one guard diodes is further connected to a guard pad by means of a plurality of guard contacts.

In an advantageous embodiment the guard diode is positioned on one side of the array of photodiodes. The image sensing device preferably comprises two guard diodes.

In a preferred embodiment the guard pad is further arranged for draining charge. The guard pad is typically of metallic material, e.g. of gold.

In another preferred embodiment the bond pads at least partially cover the area between the photodiodes and the at least one guard diode.

### Short description of the drawings

Fig. 1 represents the incidence of photons on two diodes on a wafer chip.

Fig. 2 represents an array of four photodiodes with a surrounding guard diode (prior art).

Fig. 3 represents the main drawback of the prior art solution.

Fig. 4 represents the solution according to the invention.

Fig. 5 represents a cross section of Fig.4.

Fig. 6 represents a scheme with pixels that are spatially not well defined.

Fig. 7 represents a solution to the drawback of the scheme shown in Fig.6.

### Detailed description of the invention

The present invention discloses a design ensuring a stable and uniform bias of the guard diode and a well defined response area of each pixel in array devices where the connections to pixels and to the guard diode compete for space.

In the solution according to the invention the conducting semiconductor material under and between the bond pads connected to the pixels is used to provide a current path for charge collected by the guard. The current path is electrically isolated from the bond pads by the dielectric film under the bond pad.

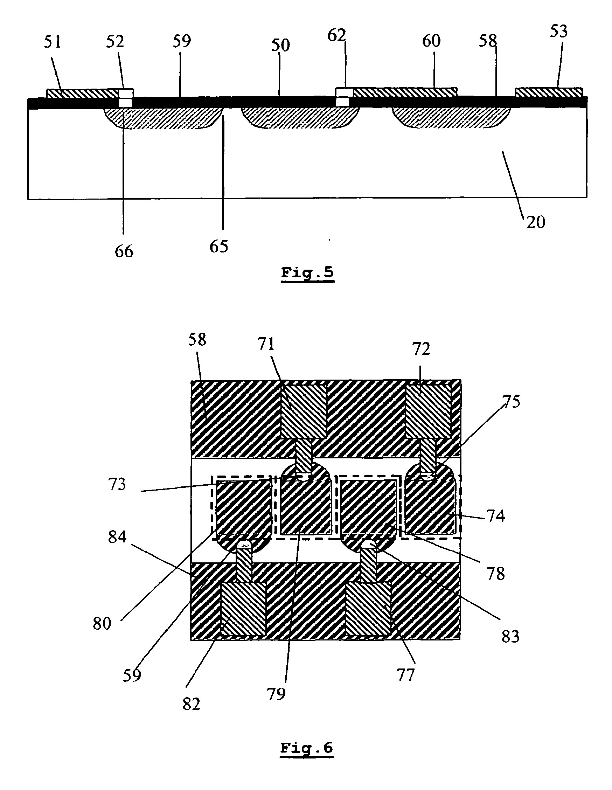

Fig.4 and Fig.5 illustrate a preferred embodiment of the invention. The cross section in Fig.5 is taken along the line AA' in Fig.4. In Fig.4, a part of an array of photodiodes is depicted. Pixel (50) is connected with a pixel contact (62) to a bond pad (60). The other pixels are connected in the same way. The guard diodes (59 and 58) on either side of the array are now extending under and/or between the bond pads. The guard diodes are connected at several points (55 and 52) called guard contacts to a continuous metal line (53 and 51) called 'guard pad' on top of the dielectric. The high conductivity of the metallic material of the guard pad makes the electrical potential along the guard pad highly uniform, even under high current conditions. Hence, the guard contacts (55 and 52) also have very uniform electrical potential. The longest current path along the guard diode (59) is approximately as long as the distance from the edge (65) of the guard diode (59) adjacent to the pixel (50) to the guard contact (66). This is significantly shorter than in devices where the current has to travel along the extension of the array as in the prior art solutions.

The guard diode has to be placed at a certain distance from the pixels. This leaves an area in between the pixel and the guard that will have light response. Also, in devices where the pixel size is small, the area of the pixel used for the contact may be of comparable size to the intended light responding area.

In Fig.6 a diode array with four pixels (80, 79, 78 and 74) is depicted. The intended light responding area is marked as four dashed rectangles. The pixels extend outside these rectangular areas in order to give space for the pixel contacts (81, 73, 84 and 75) and the bond pads (71, 72, 82 and 77). This causes area outside the intended light responding areas to be exposed and to collect light. Also, there are areas in between the pixels and the guard diode areas (58 and 59) that also collect light. Hence, the effective light collecting areas are larger than the intended light collecting areas, and the pixels are not spatially well defined.

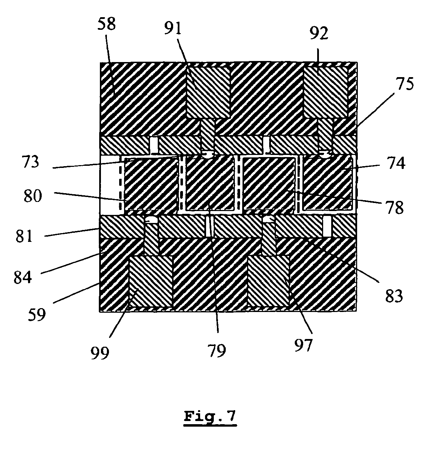

The solution to this further problem is illustrated in Fig.7, which depicts a modified version of the device depicted in Fig.6. The modification relates to the shape of the bond pads (91, 92, 99 and 97) which in the new design are given a shape that extends over the areas outside the intended response areas, but between the guard and pixel diode. The distance in between the bond pads covering such areas should be as small as possible.

The solution according to the present invention is particularly interesting for connecting a guard diode where space is an issue. The guard diode in the proposed device has no effect on the field in the pixels (imaging diodes), as the area in between is not depleted.

## Claims

1. An image sensing device comprising an array of photodiodes formed on a substrate (20) provided with a semiconductor layer, each photodiode (50) being connected with a pixel contact (62) to a bond pad (60), said bond pad being electrically isolated from said semiconductor layer, said image sensing device further comprising at least one guard diode (58), **characterised in that** said guard diode extends at least partially under and/or between said bond pads and **in that** each of said at least one guard diodes is further connected to a guard pad (53) by means of a plurality of guard contacts (55).

2. An image sensing device as in claim 1, wherein said guard diode is positioned on one side of said array of photodiodes.

3. An image sensing device as in claim 1 or 2, wherein said guard pad is further arranged for draining charge.

4. An image sensing device as in any of claims 1 to 3, comprising two guard diodes.

5. An image sensing device as in any of the previous claims, wherein said guard pad is of metallic material.

6. An image sensing device as in any of the previous claims, wherein said bond pads at least partially cover the area between said photodiodes and said at least one guard diode.

## Patentansprüche

1. Bilderfassungsvorrichtung, umfassend ein Photodioden-Array, das auf einem Substrat (20) gebildet wird, das mit einer Halbleiterschicht versehen ist, wobei jede Photodiode (50) über einen Pixelkontakt (62) an ein Anschlusspfad (60) angeschlossen ist, wobei das Anschlusspfad von der Halbleiterschicht elektrisch isoliert ist, wobei die Bilderfassungsvorrichtung ferner mindestens eine Schutzdiode (58) umfasst, **dadurch gekennzeichnet, dass** die Schutzdiode sich mindestens teilweise unter und/oder zwischen den Anschlusspfaden erstreckt, und dass jede der mindestens einen Schutzdioden ferner über eine Vielzahl von Schutzkontakten (55) an ein Schutzpfad (53) angeschlossen ist.

2. Bilderfassungsvorrichtung nach Anspruch 1, wobei die Schutzdiode auf einer Seite des Photodioden-Arrays angeordnet ist.

3. Bilderfassungsvorrichtung nach Anspruch 1 oder 2, wobei das Schutzpfad ferner zum Ladungsdrainen eingerichtet ist.

4. Bilderfassungsvorrichtung nach einem der Ansprüche 1 bis 3, die zwei Schutzdioden umfasst.

5. Bilderfassungsvorrichtung nach einem der vorhergehenden Ansprüche, wobei das Schutzpfad aus metallischem Material besteht.

6. Bilderfassungsvorrichtung nach einem der vorhergehenden Ansprüche, wobei die Anschlusspfade mindestens teilweise die Fläche zwischen den Photodioden und die mindestens eine Schutzdiode bedecken.

## Revendications

1. Dispositif de capture d'image comprenant un réseau de photodiodes formées sur un substrat (20) pourvu d'une couche semi-conductrice, chaque photodiode (50) étant connectée par un contact de pixel (62) à un emplacement pour soudure (60), ledit emplacement pour soudure étant isolé électriquement de ladite couche semi-conductrice, ledit dispositif de capture d'image comprenant en outre au moins une diode de garde (58), **caractérisé en ce que** ladite diode de garde s'étend au moins partiellement au-dessous et/ou entre lesdits emplacements pour soudure et **en ce que** chacune desdites au moins une diodes de garde est en outre connectée à un emplacement de garde (53) au moyen d'une pluralité de contacts de garde (55).

2. Dispositif de capture d'image selon la revendication 1, dans lequel ladite diode de garde est positionnée d'un côté dudit réseau de photodiodes.

3. Dispositif de capture d'image selon la revendication 1 ou 2, dans lequel ledit emplacement de garde est en outre agencé pour drainer une charge.

4. Dispositif de capture d'image selon l'une quelconque des revendications 1 à 3, comprenant deux diodes de garde.

5. Dispositif de capture d'image selon l'une quelconque des revendications précédentes, dans lequel ledit emplacement de garde est constitué d'un matériau métallique.

6. Dispositif de capture d'image selon l'une quelconque des revendications précédentes, dans lequel lesdits emplacements pour soudure recouvrent au moins partiellement la surface entre lesdites photodiodes et ladite au moins une diode de garde.
